Europäisches Patentamt

European Patent Office

Office européen des brevets

(11) Publication number: **0 147 626**
A2

# (12) EUROPEAN PATENT APPLICATION

(21) Application number: **84114151.8**

(22) Date of filing: **23.11.84**

(51) Int. Cl.⁴: **H 01 L 27/06**
**H 01 L 21/20, H 01 L 21/76**
**H 01 L 21/82**

(30) Priority: **24.11.83 JP 219446/83**

(43) Date of publication of application:
**10.07.85 Bulletin 85/28**

(84) Designated Contracting States:
**CH DE FR GB IT LI NL SE**

(71) Applicant: **HITACHI, LTD.**
**6, Kanda Surugadai 4-chome Chiyoda-ku**
**Tokyo 100(JP)**

(72) Inventor: **Tsukuda, Kiyoshi**
**37-3, Moriyamacho-2-chome**
**Hitachi-shi(JP)**

(72) Inventor: **Hirao, Mitsuru**
**1737-169, Shirakata Tokaimura**
**Naka-gun Ibaraki-ken(JP)**

(72) Inventor: **Saito, Osamu**
**Yuhoryo 20-3, Ayukawacho-6-chome**
**Hitachi-shi(JP)**

(72) Inventor: **Watanabe, Atsuo**
**3949-3, Yamashitacho**
**Hitachiota-shi(JP)**

(72) Inventor: **Ikeda, Takahide**
**41-11, Nakaarai-4-chome**
**Tokorozawa-shi(JP)**

(72) Inventor: **Kamei, Tatsuya**
**103, Urano-Corpo. 22-3, Iwaoshicho**
**Takasaki-shi(JP)**

(74) Representative: **Patentanwälte Beetz sen. - Beetz jun.**
**Timpe - Siegfried - Schmitt-Fumian**
**Steinsdorfstrasse 10**
**D-8000 München 22(DE)**

(54) Semiconductor device comprising bipolar and MOS transistors, and method of producing the same.

(57) A semiconductor device includes a bipolar transistor (48, 152) formed in a monocrystalline silicon region (6) which is epitaxially grown from a silicon substrate (1, 41), and an MOS transistor (47, 154, 156) formed in each of silicon regions (22', 23) which are epitaxially grown on an insulating layer (2, 3) provided on the silicon substrate. The silicon regions on the insulating layer are treated as follows. When one principal surface of the silicon substrate, that is, the principal surface including the monocrystalline silicon region (6) and the silicon regions (22', 23) is heated from the outside, heat produced in the monocrystalline silicon region (6) is rapidly conducted to the silicon substrate, but heat produced in the silicon regions (22', 23) is hard to dissipate. That is, the silicon regions on the insulating layer are melted and then recrystallized. Thus, the silicon regions can be transformed into approximately monocrystalline layers, on each of which the MOS transistor is formed. Further, a vertical power transistor can be formed by providing the collector electrode of the bipolar transistor on the other principal surface of the silicon substrate.

FIG. 4

SEMICONDUCTOR DEVICE AND METHOD OF FABRICATING THE SAME

## TITLE MODIFIED
### see front page

The present invention relates to a semiconductor device and a method of fabricating the same. In more particular, the present invention relates to a semiconductor integrated circuit device in which a bipolar transistor and a plurality of metal oxide semiconductor field effect transistor or a complementary metal oxide semiconductor field effect transistor (hereinafter referred to as "CMOS transistor") are formed on the same semiconductor substrate without producing any interaction between the transistors.

Generally speaking, in an integrated circuit device including a bipolar transistor and a CMOS transistor formed on the same semiconductor substrate, a parasitic capacitance and a parasitic transistor or thyristor are formed between these transistors, and thus a malfunction is apt to be performed. Accordingly, various countermeasures have been taken for electrically isolating circuit elements from each other. For example, a dielectric isolation semiconductor integrated circuit device is disclosed in U.S. Patent No. 4,286,280 (to Sugawara) issued on August 25, 1981.

Further, the cyrstallization of an amorphous or polycrystalline substance is disclosed in U.S. Patent No. 4,371,421 (to Fan et al.) issued on February 1, 1983.

An object of the present invention is to increase the number of elements per chip in such a manner that

- 2 -  0147626

semiconductor element regions on a semiconductor substrate are isolated from each other by a groove.

Another object of the present invention is to provide a method of forming a bipolar transistor and a CMOS transistor on a semiconductor substrate at a high packing density without producing any parasitic effect between semiconductor elements, and a semiconductor device fabricated by the above method.

In a semiconductor device according to the present invention, a semiconductor layer which is epitaxally grown on a substrate, is divided by an insulating material or air into semiconductor element regions, and the element regions are isolated from each other so as not to produce any parasitic effect therebetween.

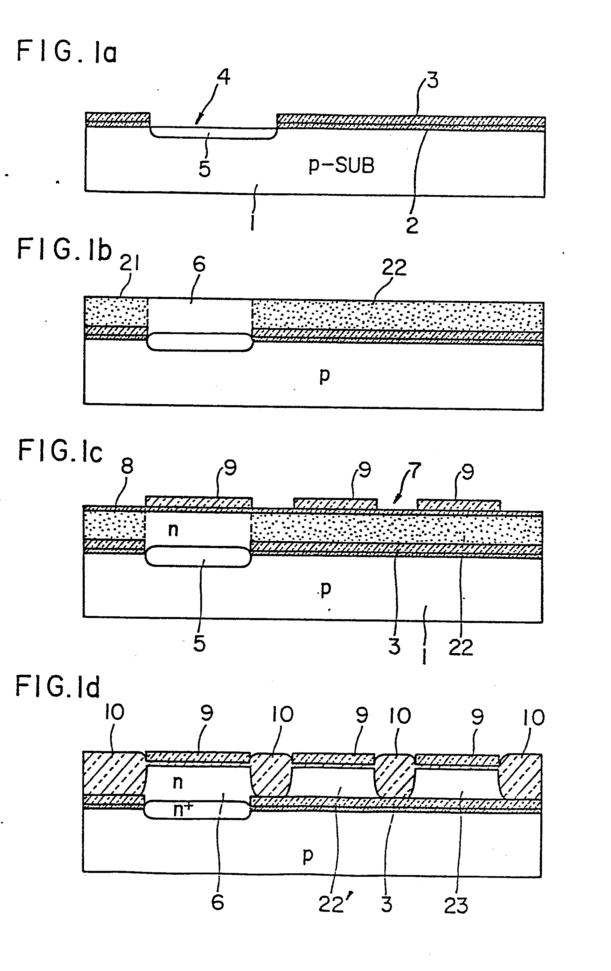

Figs. 1a through 1g, Fig. 2, Figs. 3a and 3b, Fig. 4 and Figs. 5a through 5d show various embodiments of the present invention.

Now, explanation will be made on embodiments of the present invention, with reference to the drawings.

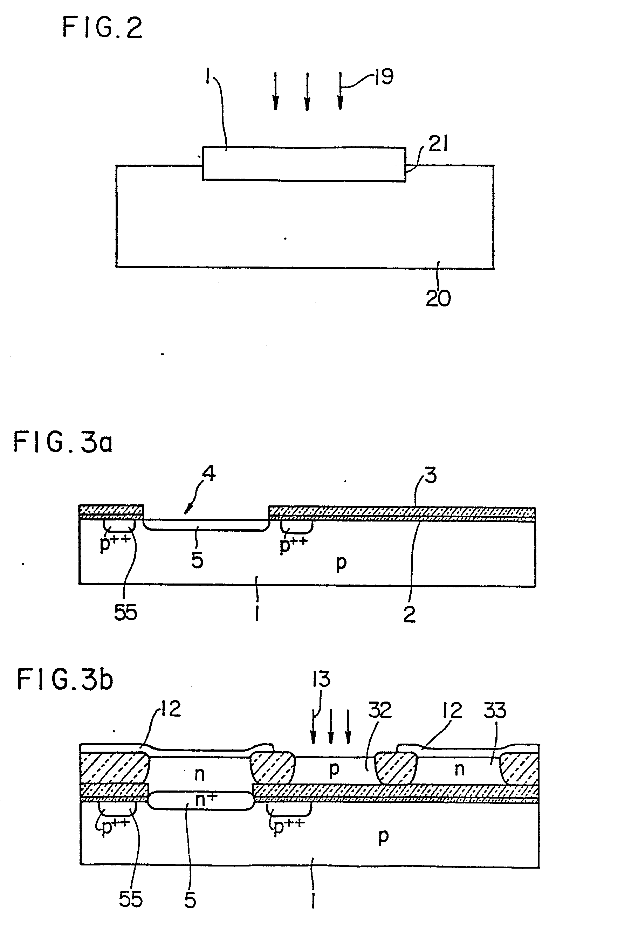

A first embodiment of the present invention will be explained below, with reference to Figs. 1a through 1g and Fig. 2.

Referring to Fig. 1a, a silicon oxide film or layer 2 (namely, $SiO_2$ layer 2) is formed on a principal surface of a P-type silicon substrate 1 which is parallel to a (100) crystallographic plane, to a thickness of 10 to 50 nm by keeping the silicon substrate 1 at about 1,000°C in the atmosphere of dry oxygen for a period of 10 to

- 3 -            0147626

60 min., that is, by the thermal oxidation method. Mixed gas of $SiH_2Cl_2$ and $NH_3$ is caused to flow at a temperature of about 770°C and a pressure of 80 Pa for a period of 20 to 100 min., while keeping the flow rates of $SiH_2Cl_2$ and $NH_3$ at 0.03 ℓ/min. and 0.33 ℓ/min., respectively. Thus, a silicon nitride layer 3 having a thickness of 50 to 200 nm is deposited on the $SiO_2$ layer 2 by chemical vapor deposition. The composition of the silicon nitride layer 3 is such that an atomic ratio of silicon to nitrogen lies in a range from 0.7 to 1.1, and the silicon nitride layer 3 is typically made of $Si_3N_4$. The layers 2 and 3 in a predetermined region are removed by the well-known photolithographic techniques, to form a window 4. The present inventors formed the window 4 in such a manner that the layers 2 and 3 were selectively etched by the sputtering which is carried out for a period of 1 to 3 min. in the atmosphere of $CF_4$ gas having a pressure of about 50 Pa and kept at a temperature of about 80°C, and consumes a power of 100 W.

Thereafter, a diffusion source $Sb_2O_3$ is heated to about 1,175°C, to be sublimated, and the vaporized Sb is diffused (or driven) from the bottom of the window 4 into the silicon substrate 1, to form a diffusion layer 5. In this diffusion process, the layers 2 and 3 function as a mask. The diffusion layer 5 is not always indispensable for a dielectric isolation semiconductor device according to the present invention, but will be effectively used as the buried collector layer of a bipolar transistor formed in a semiconductor region on the diffusion layer 5.

Referring to Fig. 1b, an epitaxial silicon layer is grown on the silicon substrate 1 including the layers 2, 3 and 5, at a temperature of 900 to 1,000°C by mixed gas of $SiCl_4$ and $H_2$. In more detail, a monocrystalline silicon layer 6 is grown on the buried layer 5, and polysilicon layers 21 and 22 having a depth of 0.3 to 3 μm are grown on the silicon nitride layer 3. The layers 6, 21 and 22 are doped with a small quantity of phosphorus to have the N-type conductivity, that is, phosphorus is doped into these layers at an impurity concentration of $5 \times 10^{14}$ to $5 \times 10^{15}$ $cm^{-3}$ using phosphine ($PH_3$) gas between 900 to 1000°C.

Referring to Fig. 1C, an $SiO_2$ layer 8 is then formed on the layers 6, 21 and 22 to a thickness of 10 to 50 nm, using the same fabricating conditions as in forming the $SiO_2$ layer 2 on the silicon substrate 1 by the thermal oxidation method, and then a silicon nitride layer 9 is deposited on the $SiO_2$ layer 8 to a thickness of 50 to 200 nm, using the same fabricating conditions as in forming the silicon nitride layer 3. Those portions of the silicon nitride layer 9, under which isolation grooves are to be provided for separating MOS and bipolar transistors on the substrate 1, are selecting dry-etched off by $CF_4$-4% $O_2$ plasma over a width of about 1 μm or more through the well-known photoresist techniques (Freon is the trade name of $CF_4$). In this etching process, the exposed surface of the $SiO_2$ layer 8 may be slightly etched. Then, the substrate 1 treated is placed in the atmosphere of wet oxygen having a temperature of about 1,000°C and a pressure of about

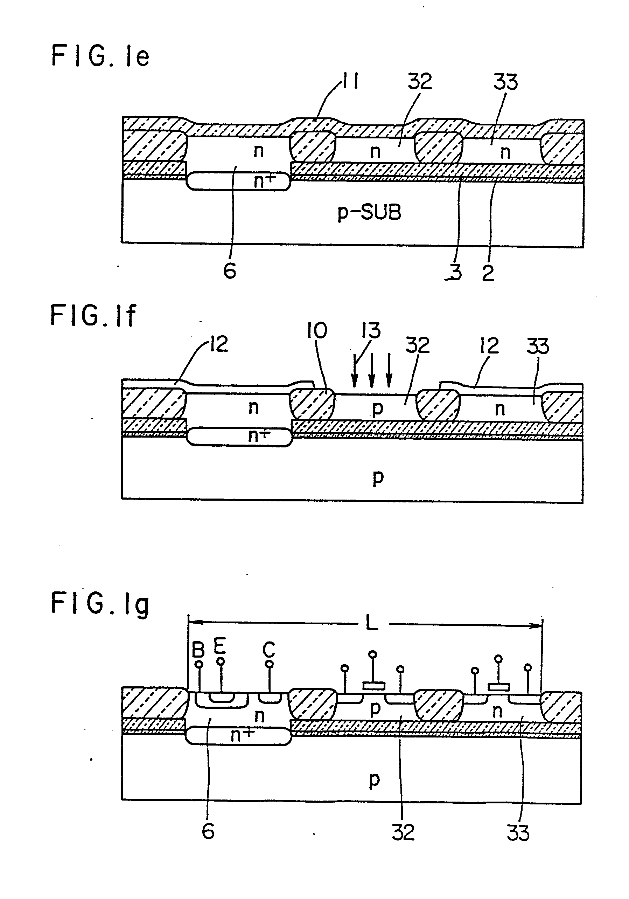

6 Kg/cm², for a period of 40 to 120 min., to selectively form a thermal oxidation film 10 having a width of 1 to 3 μm and a thickness of 1 to 2 μm (that is, a thickness capable of reaching the silicon nitride layer 3), on the basis of a difference in permeability to oxygen gas between the silicon nitride layer 9 and $SiO_2$ layer 8. Thus, the polysilicon layer 22 is isolated from the semiconductor regions 1 and 6 by the insulators 3 and 10, and is divided by the insulator 10 into layers 22' and 23. Each of the semiconductor regions 6, 22' and 23 is surrounded by the insulator 10, as shown in Fig. 1d. The silicon nitride layer 9 is removed by the well-known wet etching techniques by hot phosphoric acid aqueous solution at about 170°C for 30 min. and then an $SiO_2$ layer 11 is deposited to a thickness of 0.3 to 2 μm as shown in Fig. 1e, by using the thermal decomposition of $Si(OC_2H_5)_4$. Referring now to Fig. 2, the substrate 1 thus treated is placed on a carbon heater 20 which has a substrate-accepting recess 21 (0.1 - 0.5 mm depth) is pre-heated to a temperature of 1,100 to 1,300°C, and the upper side of the substrate 1 is irradiated with laser or infrared light as indicated by an arrow 19, to be rapidly heated. At this time, the $SiO_2$ layer 11 prevents the evaporation of silicon from the surfaces of molten silicon layers 6, 32 and 33. Since the bottom of the monocrystalline region 6 is kept in contact with the substrate 1 which is high in thermal conductivity, heat supplied to the region 6 is rapidly conducted to the substrate 1. While, the $SiO_2$ layer 2 and silicon nitride layer 3 which are relatively low in thermal conductivity, are interposed between the crystalline layers 22' and 23 and the substrate 1. Thus, heat supplied to the layers 22' and 23 is hard to dissipate. Accordingly, the upper side of the substrate 1 can be heated so that the monocrystalline silicon layer 6 is not melted but only the polysilicon layers 22' and 23 are melted. That is, the polysilicon layers 22' and 23 can be transformed into the approximately monocrystallized layers 32 and 33, without giving any adverse effect on the monocrystalline silicon layer 6. Although the bottom and side portions of each of the layers 32 and 33 may be monocrystallized imperfectly, such imperfect monocrystalline portions will not arouse a serious problem when an MOS transistor is formed in each of these layers 32 and 33. The $SiO_2$ layer 11 is then removed by the well-known etching techniques (for example, by the etchant HF and $NH_4F$ at about 25°C).

Next, a photoresist film 12 is selectively formed by the well-known photoresist techniques to a thickness of 0.5 to 1.5 μm, as shown in Fig. 1f, and boron ions are implanted into the approximately monocrystallized layer 32 with an implant energy of about 60 KeV, to form a P-type silicon layer 32 which is approximately monocrystallized and has an impurity concentration of 0.5 to 3 x $10^{12}$ $cm^{-3}$. At this time, the N-type silicon layers 6 and 33 are left unchanged. The photoresist film 12 is then removed. Thereafter, as shown in Fig. 1g, a bipolar transistor, an N-channel MOS transistor, and a P-channel MOS transistor are formed in the N-type monocrystalline silicon layer 6, the P-type approximately-monocrystallized silicon layer 32, and the N-type approximately-monocrystallized silicon layer 33, respectively, through well-known semiconductor techniques. The N-channel MOS transistor and P-channel MOS transistor are connected to each other to form a CMOS transistor. When a 1 μm rule is applied to form the bipolar transistor having 7 μm width and the MOS transistors 3 μm width, the total width L of one bipolar and two CMOS transistors will be 15 μm if the width of the each $SiO_2$ layer 10 is 1 μm.

For more narrow width L, the Si epitaxial layer having a 0.5 μm is preferable to provide the narrow width of the $SiO_2$ layer 10, about 0.5 μm, and the 0.7 μm rule is applied to obtain the width L of 13 x 0.7 + 2 x 0.5 ≑ 10 μm.

The step shown in Fig. 1f may be omitted to obtain a second embodiment of the present invention. In this case, two MOS transistors can be formed by providing two N-channel MOS transistors on the layers 32 and 33.

One of the MOS transistors may be coupled with the base of the bipolar transistor to form a bi-MOS transistor having a high input impedance.

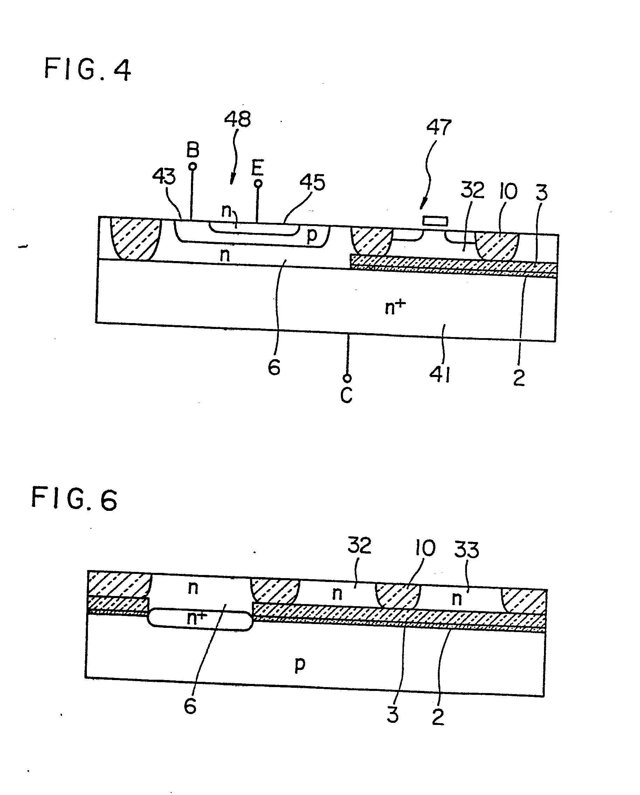

A third embodiment of the present invention will be explained, with reference to Fig. 4. An $N^+$-silicon substrate 41 having a principal surface paralle to a (100) crystallographic plane and an impurity concentration of $10^{19}$ to $10^{21}$ $cm^{-3}$ is first prepared. Then, various layers are formed by using fabricating conditions corresponding to the fabricating conditions which have been explained with reference to Figs. la through lg.  In Fig. 4, these layers are designated by the same reference numerals as in Fig. la through lg.  Thereafter, a P-type base region 43 is formed, by the well-known ion implantation method, in the N-type epitaxially-grown layer 6 which is kept in direct contact with the substrate 41, and an N-type emitter region 45 is formed in the P-type base region 43 by the ion implantation method.  A contact electrode is provided on each of the base region 43 and emitter region 45.  Further, a collector contact electrode is provided on a principal surface of the substrate 41 opposite to the monocrystalline silicon layer 6.  Thus, a vertical NPN power transistor 48 is obtained which is large in current passing area.  The power transistor 48 can be driven by an MOS transistor 47 formed in the P-type or N-type approximately-monocrystallized silicon region 32.

A fourth embodiment of the present invention is different from the above-mentioned third embodiment in that a bipolar transistor is formed in the region 32 to drive the power transistor 48.

A fifth embodiment of the present invention is different from the third embodiment in that a P-type substrate is used for forming a PNP power transistor in place of the NPN power transistor 48.

A sixth embodiment of the present invention will be explained below, with reference to Figs. 3a and 3b. In Figs. 3a and 3b, the same layers as in Figs. la through lg are designated by the same reference numerals.  Referring to Figs. 3a and 3b, prior to forming the $SiO_2$ layer 2 on the substrate 1 by the thermal oxidation method, a ring-shaped, highly-doped, $P^{++}$-layer 55 is formed in the substrate 1 by the photolithographic techniques and ion implantation method. Thereafter, the substrate 1 is treated in the same manner as having been explained with reference to Figs. 1b to 1f. The substrate thus obtained is shown in Fig. 3a. The ring-shaped buried layer 55 is very effective for electrically isolating the buried collector layer 5 from a plurality of bipolar/CMOS transistors formed in that surface portion of the substrate 1 which is not shown in Figs. 3a and 3b.

Next, a seventh embodiment of the present invention is shown in which, prior to forming the insulator 10 of Fig. 1d, laser heating is carried out. According to the present embodiment, a (100) crystallographic plane can be formed in respective surfaces of the regions 22' and 23 as in the principal surface of the substrate 1.

An eighth embodiment of the present invention will be explained, with reference to Fig. 6. After having removed the $SiO_2$ layer 11 of Fig. 1e, dry etching is carried out till a flat surface is formed on the insulator 10 and silicon layers 6, 32 and 33. In this case, a circuit element formed on the substrate improves in dimensional accuracy and performance.

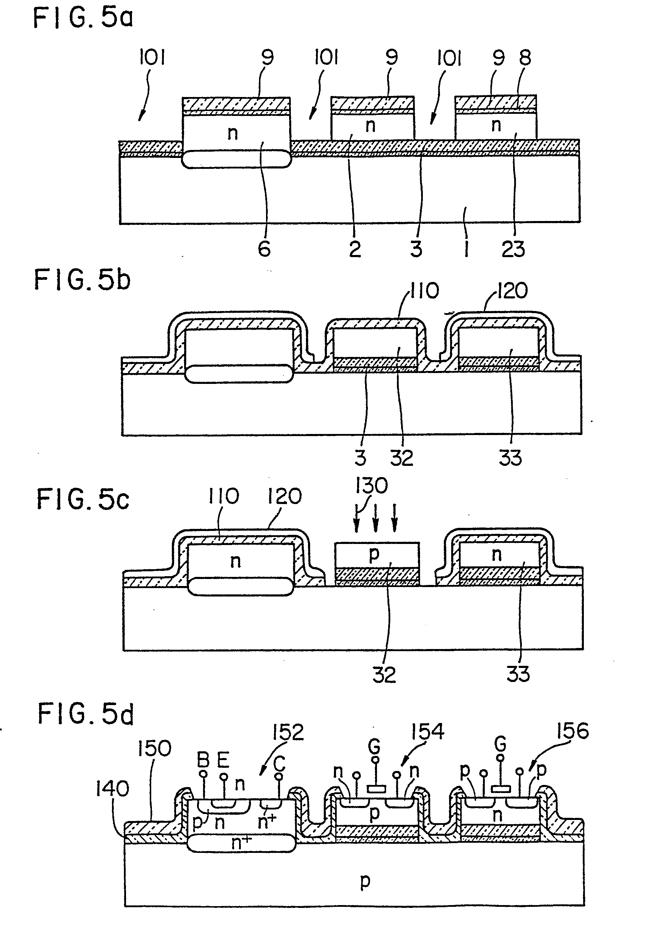

A ninth embodiment of the present embodiment is shown in Figs. 5a through 5d. The substrate 1 is prepared in accordance with the steps shown in Figs. 1a to 1c. Then,

- 10 -          0147626

as shown in Fig. 5a, the polysilicon layers 21 and 22 of the substrate 1 are selectively etched by the etchant of KOH : $H_2O$ : IPA (isopropyl alcohol) = 1000 g : 2333 ml : 200 ml at about 75°C to a depth reaching the silicon nitride layer 3 by using the silicon nitride layer 9 as a mask, and thus circuit element regions are separated from each other by air in an empty space 101. Then, the polysilicon layers 22 and 23 which are left unetched, are approximately monocrystallized by the heat treatment using laser or infrared light. At this time, the monocrystalline silicon layer 6 is not melted. The above heat treatment may be carried out between the step shown in Fig. 1C and the step shown in Fig. 5a. The portion of the silicon nitride layer 3 lying at the bottom of the empty space 101 and the silicon nitride layer 9 on each circuit element region are etched off by the hot $H_3PO_4$-$H_2O$ at about 170°C for 30 min.. Then, as shown in Fig. 5b, an $SiO_2$ layer 110 is deposited on the substrate 1 to a thickness of 0.3 to 2.0 µm by the thermal decomposition method, and a photoresist film 120 having a thickness of 0.5 to 1.5 µm is provided on two islands other than a center island. The $SiO_2$ layer 110 on the center island is etched off by using the photoresist film 120 as a mask. Thereafter, as indicated by an arrow 130 in Fig. 5C, boron ions are implanted into the approximately monocrystallized silicon layer 32 which is the center island, with an implant energy of about 60 KeV, to form a P-type layer having an impurity concentration of 0.5 to 3 x $10^{12}$ $cm^{-3}$.

The photoresist film 120 and $SiO_2$ layer 110 are

etched off. A phosphosilicate glass film 140 is deposited in the empty regions 101 by the plasma CVD method to a thickness of 0.2 to 1.5 μm and then a silicon nitride or oxide film 150 is deposited on the phosphosilicate glass film 140 by the plasma CVD method to a thickness of 0.1 to 1.0 μm, as shown in Fig. 5d. The deposition of these films 140 and 150 is carried out, while using a photoresist film (not shown) on the three islands as a mask. An NPN transistor 152, an N-channel MOS transistor 154 and a P-channel MOS transistor 156 are formed in the silicon layers 6, 32 and 33 forming the three islands, respectively. The N-channel MOS transistor 154 and P-channel MOS transistor 156 are connected to each other to form a CMOS transistor.

In all embodiments described above, narrow dielectric isolation layer can be formed, without producing a parasitic element, in accordance with the invention. Accordingly, the compact or high density integrated circuit having a bipolar and MOS transistors can be presented.

CLAIMS:

1.      A semiconductor device comprising:

     (a)    a first dielectric layer (2, 3) formed on one of a pair of principal surfaces of a semiconductor substrate (1, 41);

     (b)    a first semiconductor layer (6) epitaxially grown on said semiconductor substrate at a region of said one principal surface, said first dielectric layer being absent in said region;

     (c)    a plurality of second semiconductor layers (32, 33) grown on said first dielectric layer epitaxially from said semiconductor substrate through said first semiconductor layer; and

     (d)    a plurality of second dielectric layers (10) kept in contact with said first dielectric layer for separating said first semiconductor layer from said second semiconductor layers and for separating said second semiconductor layers from each other.

2.      A semiconductor device according to Claim 1, further comprising a bipolar transistor (48) formed in a semiconductor region including said first semiconductor layer, and a plurality of MOS transistors (47) formed in another semiconductor region including said second semiconductor layers.

3.      A semiconductor device according to Claim 1, further comprising a bipolar transistor circuit (152) formed in a semiconductor region including said first semiconductor layer, and an N-channel MOS transistor (154) and a P-channel MOS transistor (156) formed in a semiconductor region including said second semiconductor layers, for forming a CMOS transistor circuit.

4. A semiconductor device according to Claim 3, wherein said bipolar transistor includes an electrode provided on the other principal surface of said semiconductor substrate.

5. A semiconductor device according to Claim 1, wherein said first semiconductor layer (6) and said second semiconductor layers (32, 33) are substantially monocrystalline.

6. A semiconductor device according to Claim 5, wherein said first and second substantially-monocrystalline layers are formed by placing said semiconductor substrate on a heater (20) kept at a temperature of 1100 to 1300°C and by heating said semiconductor substrate from the upside thereof by one of laser light and infrared light.

7. A method of fabricating a semiconductor device, comprising steps of:

(a) forming a first dielectric layer (2, 3) on one principal surface of a monocrystalline silicon substrate (1, 41), said principal surface being parallel to a (100) crystallographic plane;

(b) partially removing said first dielectric layer;

(c) epitaxially growing silicon layer (6, 22) on said silicon substrate; and

(d) separating said epitaxially-grown silicon layer in such a manner that a first silicon layer (6) formed in a semiconductor region devoid of said first dielectric layer is separated from a plurality of second silicon layers (22', 23) formed on said first dielectric layer, by a separation layer (10), and said second silicon layers are separated from each other by another separation layer (10).

8. A method of fabricating a semiconductor device as claimed in Claim 7, wherein said separation layers (10) are formed by selectively oxidizing said epitaxially-grown silicon layer (6, 22) while using a third dielectric layer (9) provided on said epitaxially-grown silicon layers (6, 22), as a mask.

9. A method of fabricating a semiconductor device as claimed in Claim 7, further comprising a step of heating said epitaxially-grown silicon layer to a temperature of 1,300 to 1,400°C to substantially monocrystallize said epitaxially-grown silicon layer.

10. A method of fabricating a semiconductor device as claimed in Claim 9, further comprising a step of forming a bipolar transistor circuit (48) in a semiconductor region including said first silicon layer, and forming a CMOS transistor circuit (47) in another semiconductor region including said second silicon layers.

11. A method of fabricating a semiconductor device as claimed in Claim 7, wherein said separating step includes a step of forming grooves (101) by selectively etching off said epitaxially-grown silicon layer (6, 22) to a depth reaching said first dielectric layer, and another step of forming a fourth dielectric layer (140, 150) in each of said grooves (101).

12.      A method of fabricating a semiconductor device as claimed in Claim 11, further comprising a step of forming a bipolar transistor circuit (152) in a semiconductor region including said first silicon layer (6), and forming a CMOS transistor circuit (154, 156) in another semiconductor region including said second silicon layers (22', 23).

0147626

FIG. 1a

FIG. 1b

FIG. 1c

FIG. 1d

0147626

FIG. 1e

FIG. 1f

FIG. 1g

0147626

FIG.2

FIG.3a

FIG.3b

## FIG. 4

B · 48
43 · E · 45 · 47 · 32 · 10 · 3

n
p
n
n⁺

6 · C · 41 · 2

## FIG. 6

32 · 10 · 33

n · n · n
n⁺
p

6 · 3 · 2

515

0147626

FIG.5a

FIG.5b

FIG.5c

FIG.5d